# EUROPEAN PATENT APPLICATION

(11) **EP 3 493 328 A1**
(43) Date of publication of application: **05.06.2019**
(21) Application number: 17834318.2
(22) Date of filing: 25.07.2017
(51) Int. Cl.: H01Q 1/52, H01Q 13/08, H01Q 21/06

(54) **PLANAR ARRAY ANTENNA AND QUASI-MILLIMETER WAVE/MILLIMETER WAVE WIRELESS COMMUNICATION MODULE**

(30) Priority: 29.07.2016 JP 2016149644; 09.12.2016 JP 2016239306
(71) Applicant: Hitachi Metals, Ltd., Tokyo 108-8224 (JP)
(72) Inventor: HAYASHI Kenji, Minato-ku, Tokyo 108-8224 (JP); TAKAKI Yasunori, Minato-ku, Tokyo 108-8224 (JP)
(74) Representative: Fleuchaus, Michael A.
(86) International application number: PCT/JP2017/026878
(87) International publication number: WO 2018/021316

(57) **Abstract**

A planar array antenna includes: a radiation section **51** including a plurality of radiation conductors **30** and a first ground conductor layer **20,** and a power supply section **52** including a plurality of strip conductors **10** and a second ground conductor layer **60,** wherein the strip conductors **10** are arranged so as to correspond to the radiation conductors **30** between the first ground conductor layer **20** and the second ground conductor layer **60;** and the first ground conductor layer **20** is located between the radiation conductors **30** and the corresponding strip conductors **10,** and includes a plurality of slots **21** extending in a direction that crosses a direction in which the strip conductor **10** extends and a groove or at least one aperture **22** located between adjacent two of the slots **21.**

## Description

### TECHNICAL FIELD

The present disclosure relates to a planar array antenna, and a quasi-millimeter wave/millimeter wave wireless communication module.

### BACKGROUND ART

A planar antenna may be used in high frequency wireless communication. For example, Patent Documents No. 1, No. 2 and No. 3 each disclose a planar antenna, wherein slots are formed in the conductor layer so as to supply power to radiation conductors. Particularly, Patent Document No. 2 discloses a planar array antenna including a plurality of planar antennas. Specifically, it discloses a planar array antenna including a plurality of strip conductors, a conductor layer provided with a plurality of slots, and a plurality of radiation conductors arranged so as to cover the slots.

### CITATION LIST

### PATENT LITERATURE

Patent Document No. 1: Japanese Laid-Open Patent Publication No. 2013-201712
Patent Document No. 2: Japanese Laid-Open Patent Publication No. H06-291536
Patent Document No. 3: Japanese Laid-Open Patent Publication No. H07-046033

### SUMMARY OF INVENTION

### TECHNICAL PROBLEM

A planar array antenna can enhance the radiation characteristic by combining together electromagnetic waves emitted from a plurality of planar antennas. It is an object of the present application to provide a planar array antenna and a quasi-millimeter wave/millimeter wave wireless communication module with which it is possible to realize a good radiation characteristic.

### SOLUTION TO PROBLEM

A planar array antenna of the present disclosure includes: a radiation section including a plurality of radiation conductors and a first ground conductor layer; and a power supply section including a plurality of strip conductors and a second ground conductor layer, wherein: the strip conductors are arranged so as to correspond to the radiation conductors between the first ground conductor layer and the second ground conductor layer; and the first ground conductor layer is located between the radiation conductors and the corresponding strip conductors, and includes a plurality of slots extending in a direction that crosses a direction in which the strip conductor extends and a groove or at least one aperture located between adjacent two of the slots.

The radiation conductors and the strip conductors may be arranged two-dimensionally in a first direction and in a second direction perpendicular to the first direction.

The first ground conductor layer may have a plurality of apertures, and the apertures may be arranged in the first direction and in the second direction.

The first ground conductor layer may have a plurality of apertures, and the apertures may be arranged only in one of the first direction and the second direction.

The first ground conductor layer may have a plurality of grooves, and the grooves may be arranged in the first direction and in the second direction.

The first ground conductor layer may have a plurality of grooves, and the grooves may be arranged only in one of the first direction and the second direction.

The planar array antenna may further include dielectric layers located between the radiation conductors and the first ground conductor layer, between the first ground conductor layer and the strip conductors, and between the strip conductors and the second ground conductor layer.

The planar array antenna may further include a plurality of ceramic layers, wherein the radiation conductors, the first ground conductor layer, the strip conductors and the second ground conductor layer may be located between the ceramic layers.

The planar array antenna may further include a dielectric layer that covers the radiation conductors.

The grooves or at least one aperture of the first ground conductor layer may be cavities.

The grooves or at least one aperture of the first ground conductor layer may be filled with the same ceramic as the ceramic of the ceramic layers.

A quasi-millimeter wave/millimeter wave wireless communication module includes: the planar array antenna set forth above; and an active component that is electrically connected to the planar array antenna.

### ADVANTAGEOUS EFFECTS OF INVENTION

According to the present disclosure, it is possible to realize a planar array antenna and a quasi-millimeter wave/millimeter wave wireless communication module which have a good radiation characteristic and with which it is possible to suppress the interference between the electromagnetic waves radiated from the radiation conductor of the array antenna.

### BRIEF DESCRIPTION OF DRAWINGS

FIG. **1** is a plan view schematically showing a planar array antenna of a first embodiment.
FIG. **2(a)** is a cross-sectional view of a planar array antenna taken along line 2A-2A of FIG. **1****,** and FIGS. **2(b)** to **2(d)** are plan views schematically showing elements of the planar array antenna taken along line 2A-2A of FIG. **1****.**
FIG. **3** is a plan view schematically showing a first ground conductor layer of the planar array antenna shown in FIG. **1****.**
FIG. **4** is a plan view showing another example of apertures provided in the first ground conductor layer of the planar array antenna.
FIG. **5** is a plan view showing another example of apertures provided in the first ground conductor layer of the planar array antenna.
FIG. **6** is a plan view showing another example of apertures provided in the first ground conductor layer of the planar array antenna.
FIG. **7** is a plan view showing another example of apertures provided in the first ground conductor layer of the planar array antenna.
FIG. **8** is a plan view showing another example of apertures provided in the first ground conductor layer of the planar array antenna.
FIG. **9** is a cross-sectional view schematically showing a planar array antenna according to another example of the first embodiment.
FIG. **10** is a cross-sectional view showing an example of a multilayer ceramic substrate of the first embodiment in which a planar array antenna and a wiring circuit are formed.
FIG. **11(a)** is a schematic bottom view showing an embodiment of a wireless communication module, and FIG. **11(b)** is a schematic cross-sectional view showing a wireless communication module mounted on a substrate.
FIG. **12** shows the radiation characteristic of a planar array antenna of Example 1 determined by calculation.
FIG. **13** shows the radiation characteristic of a planar array antenna of Example 2 determined by calculation.
FIG. **14** shows the radiation characteristic of a planar array antenna of Example 3 determined by calculation.
FIG. **15** shows the radiation characteristic of a planar array antenna of Example 4 determined by calculation.
FIG. **16** shows the radiation characteristic of a planar array antenna of Example 5 determined by calculation.
FIG. **17** shows another embodiment of a planar array antenna, wherein FIG. **17(a)** is a cross-sectional view of the planar array antenna at the position corresponding to line 2A-2A of FIG. **1****,** and FIGS. **17(b)** to **17(e)** are plan views schematically showing elements of the planar array antenna at the position corresponding to line 2A-2A of FIG. **1****.**
FIG. **18** shows another embodiment of a planar array antenna, wherein FIG. **18(a)** is a cross-sectional view of the planar array antenna at the position corresponding to line 2A-2A of FIG. **1**, and FIGS. **18(b)** to **18(d)** are plan views schematically showing elements of the planar array antenna at the position corresponding to line 2A-2A of FIG. **1****.**

### DESCRIPTION OF EMBODIMENTS

The present inventors made an in-depth study on improving the radiation characteristic of a planar antenna array including a plurality of planar antennas, wherein power is supplied to the planar antennas from strip conductors via slots. As a result, the present inventors found that when a plurality of slots are provided in a planar antenna so as to supply power to the radiation conductor of the planar antenna, interference of electromagnetic waves occurs, thereby deteriorating the radiation characteristic, thus arriving at a planar array antenna having a novel structure with which it is possible to suppress interference of electromagnetic waves.

The planar array antenna of the present disclosure is applicable to wireless communication of a quasi-millimeter wave/millimeter wave band, for example. With wireless communication of a millimeter wave band, a radio wave whose wavelength is 1 mm to 10 mm and whose frequency is 30 GHz to 300 GHz is used as the carrier wave. With wireless communication of a quasi-millimeter wave band, a radio wave whose wavelength is 10 mm to 30 mm and whose frequency is 10 GHz to 30 GHz is used as the carrier wave. With wireless communication of a quasi-millimeter wave/millimeter wave band, the size of the planar antenna is several centimeters or on the order of millimeters. Therefore, when a quasi-millimeter wave/millimeter wave wireless communication circuit is formed by using a multilayer ceramic sintered substrate (e.g., a multilayer ceramic substrate **102**), for example, the planar array antenna of the present disclosure can be mounted on a multilayer ceramic sintered substrate.

### (First embodiment)

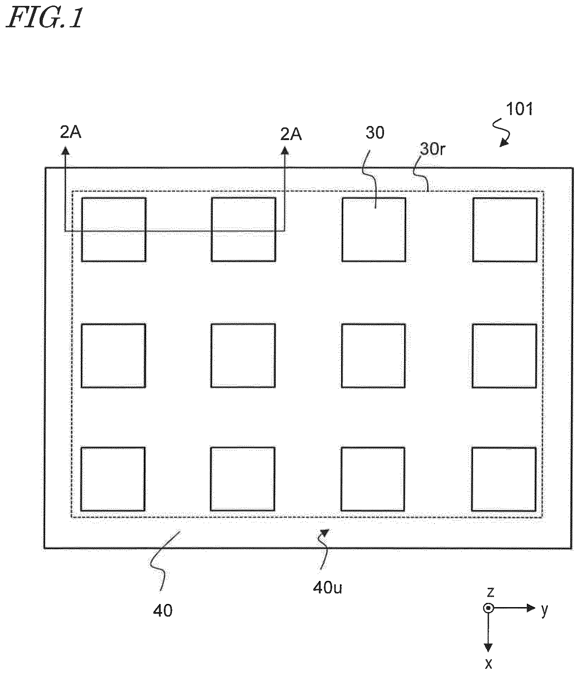

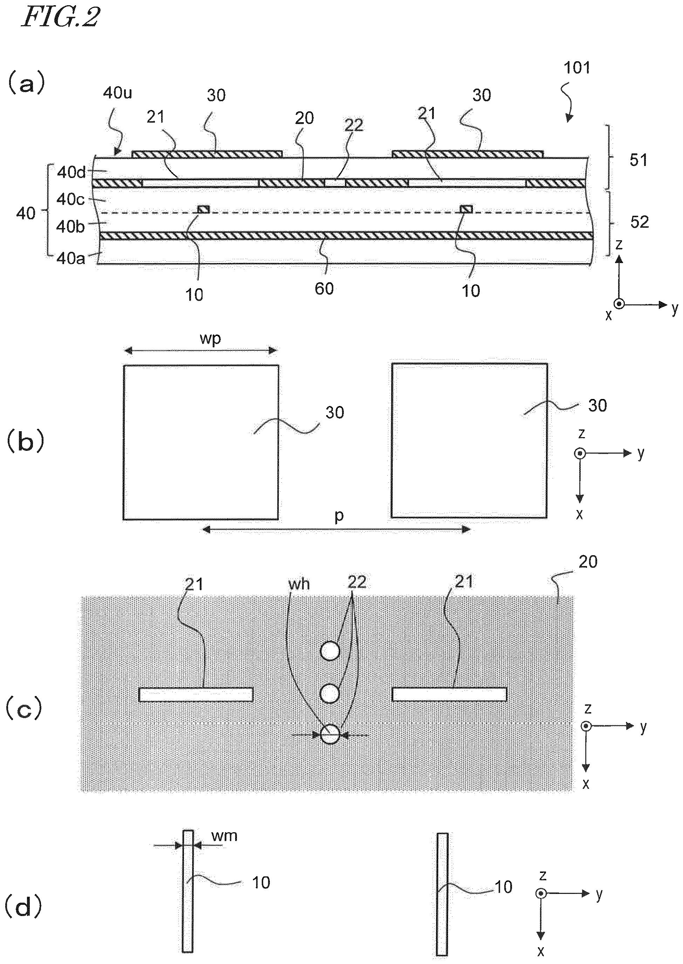

FIG. **1** is a plan view showing an embodiment of a planar array antenna **101** of the present disclosure. A plurality of radiation conductors **30** are arranged in an array on an upper surface **40u** of a multilayer ceramic body **40.** In the present embodiment, the radiation conductors **30** are arranged two-dimensionally in the x direction (the first direction) and in the y direction (the second direction) perpendicular to the x direction, forming an array, as shown in FIG. **1**. FIG. **2(a)** is a cross-sectional view of the planar array antenna **101** taken along line 2A-2A of FIG. **1****.**

The planar array antenna **101** includes a radiation section **51** and a power supply section **52.** The power supply section **52** and the radiation section **51** are electromagnetically coupled together, and the radiation section **51** receives the signal power supplied from the power supply section **52** to radiate electromagnetic waves from the radiation conductors **30.** The radiation section **51** includes a plurality of radiation conductors **30** and a first ground conductor layer **20.** The power supply section **52** includes a plurality of strip conductors **10** and a second ground conductor layer **60.** Each of the strip conductors **10** is located between the first ground conductor layer **20** and the second ground conductor layer **60,** and is arranged corresponding to one radiation conductor **30.** That is, as seen from the z direction, which is the direction of lamination of these components, at least a portion of each strip conductor **10** overlaps with the corresponding radiation conductor **30.** FIG. **2(b),** FIG. **2(c)** and FIG. **2(d)** are plan views of the radiation conductor **30,** the first ground conductor layer **20** and the strip conductor **10** shown in the 2A-2A cross section.

A dielectric layer is located between the radiation conductor **30,** the first ground conductor layer **20,** the strip conductor **10** and the second ground conductor layer **60.** The dielectric layer may be a resin layer, a glass layer, a ceramic layer, a cavity, etc. In the present embodiment, the dielectric layer is a ceramic layer, and the planar array antenna **101** is configured as a multilayer ceramic substrate including the radiation conductors **30,** the first ground conductor layer **20,** the strip conductors **10** and the second ground conductor layer **60** provided in the multilayer ceramic body **40** including a plurality of ceramic layers. An example where the planar array antenna **101** is formed by using a multilayer ceramic substrate will be described later.

The radiation conductors **30** are radiating elements for radiating radio waves, and are formed from a conductive layer. For example, in the present embodiment, each radiation conductor **30** has a rectangular (square) shape. However, the radiation conductors may have a circular shape or any other shape. As described above, the radiation conductors **30** form an array antenna, thereby enhancing the directionality of radio waves to be radiated or received. The pitch **p** of the radiation conductor **30** is 1/2 the wavelength λ0. Herein, Ad is the wavelength of the carrier wave through the multilayer ceramic body **40,** which is a dielectric as will be described later, and λ0 is the wavelength of the carrier wave through a vacuum.

The first ground conductor layer **20** is also formed from a conductive layer. It is preferred that the first ground conductor layer **20** is sized so as to include a region **30r** of the array of the radiation conductors **30** and is arranged with respect to the radiation conductors **30** so as to include the region **30r,** as seen from the z direction (see FIG. **1****,** FIG. **2**).

The first ground conductor layer **20** includes a plurality of slots **21.** The slots **21** are located between the radiation conductors **30** and the corresponding strip conductors **10,** and extend in the y direction perpendicular to the x direction in which the strip conductor **10** extends. The first ground conductor layer **20** having the slot **21** functions as a radiation conductor when the signal power applied to a micro strip line that is formed by the strip conductor **10** and the second ground conductor layer **60** to be described later is electromagnetically coupled to the radiation section **51** via the slot **21.** The radiation conductor **30** and the first ground conductor layer **20** having the slots **21** cause multi-resonance, increasing the bandwidth of electromagnetic waves to be radiated.

The first ground conductor layer **20** includes at least one opening located between two adjacent slots **21.** The opening is a groove or an aperture. In the present embodiment, the first ground conductor layer **20** has a plurality of apertures **22.** The slots **21** and the apertures **22** are through openings provided in the first ground conductor layer **20,** and the conductive layer is absent in these regions. As will be described below, the slots **21** and the apertures **22** may be filled with a dielectric or may be cavities. The length L of the internal circumference of a slot **21** (which corresponds to the total length of the four sides along the internal circumference) is λd. The diameter wh of an aperture **22** is λd/4 or less. The arrangement of the apertures **22** will be described below in detail.

The strip conductors **10** are formed from a conductive layer. The strip conductors **10** are arranged so as to cross the slots **21** of the first ground conductor layer **20** as seen from the z direction. In the present embodiment, the width wm of a strip conductor **10** is 140 µm, for example.

The second ground conductor layer **60** is also formed from a conductive layer. It is preferred that the second ground conductor layer **60** is sized so as to include the region **30r** of the array of the radiation conductors **30** and is arranged with respect to the radiation conductors **30** so as to include the region **30r,** as seen from the z direction (the direction of lamination of the multilayer ceramic body **40**) (see FIG. **1****,** FIG. **2**).

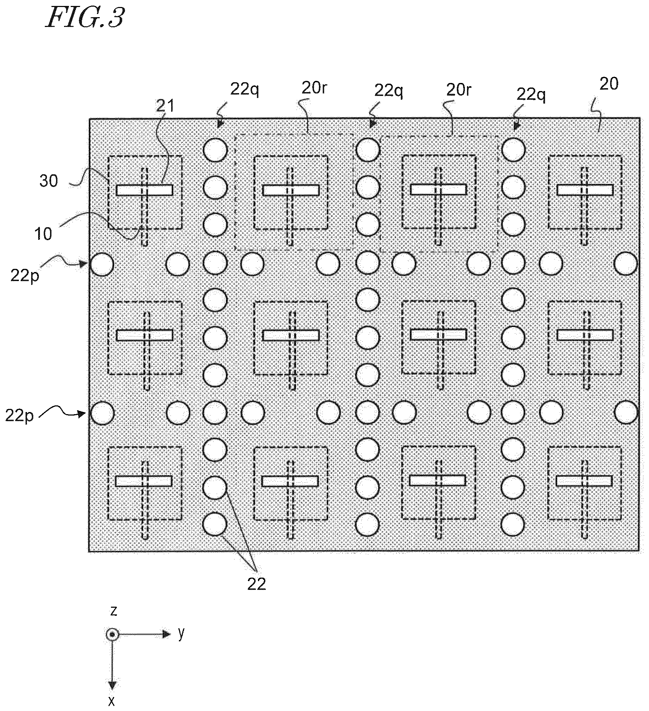

FIG. **3** is a plan view showing the entirety of the first ground conductor layer **20.** In FIG. **3****,** the positions of the radiation conductors **30** and the positions of the strip conductors **10** are indicated by broken lines. In the present embodiment, the apertures **22** are arranged in the x direction and in the y direction, each arranged between two adjacent slots **21.** For example, rows **22p** of apertures **22** and rows **22q** of apertures **22** are arranged along straight lines that are parallel to the y direction and the x direction, respectively, each row **22p** passing through the midpoint in the x direction between two adjacent slots **21** and each row **22q** passing through the midpoint in the y direction between two adjacent slots **21.** The number, diameter, position and interval of the apertures **22** influence the suppression of the interference of electromagnetic waves. The optimal values thereof dependent on the characteristics that are required of the planar array antenna **101.** The rows **22p** and the rows **22q** partition regions **20r** of the first ground conductor layer **20** from each other, each region **20r** including a slot **21.** In the region **20r,** the radiation conductor **30,** the first ground conductor layer **20,** the strip conductor **10** and the second ground conductor layer **60** located in the z direction together form a planar antenna.

With the planar array antenna **101,** the signal power applied to the micro strip line formed by each strip conductor **10** and the second ground conductor layer **60** of the power supply section **52** is electromagnetically coupled to the radiation section **51** via the slot **21,** and the electromagnetic interference between planar antennas is suppressed by the apertures **22** provided in the first ground conductor layer **20.** Thus, the interference of radio waves radiated from the radiation conductors **30** is optimized, also suppressing the decrease in radiation characteristic. As will be described below, particularly, it is possible to increase the gain difference between the main lobe and the side lobe in the radiation characteristic, and to realize a radiation characteristic with a good directionality.

With a device structure that transfers a high frequency signal or radiates high frequency electromagnetic waves, such as a planar antenna or a micro strip line, the ground conductor typically functions as an electromagnetic wave shield structure. From this point of view, it is not common to provide the apertures **22** in the ground conductor layer. For example, the laminated antenna disclosed in Japanese Laid-Open Patent Publication No. 2003-78337 includes a metal coat having a slot and a plurality of punctured portions. The punctures of the metal coat form a photonic band gap, and this is a structure for preventing electromagnetic waves from propagating through the metal coat in regions other than the slot, and is not a structure for optimizing the interference of electromagnetic waves between a plurality of planar antennas.

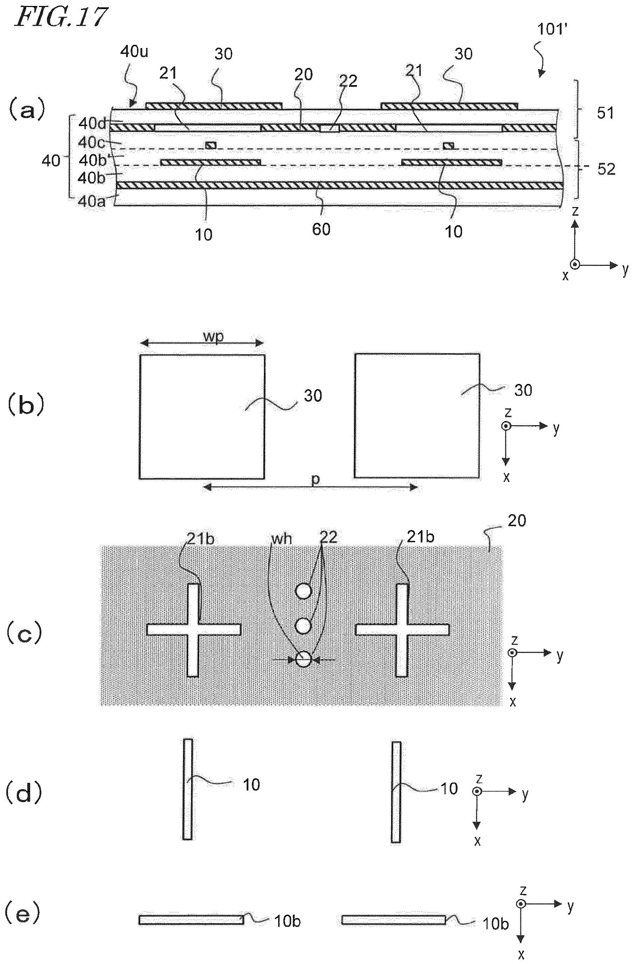

Note that for one radiation conductor **30,** the planar array antenna **101** of the embodiment described above includes the slot **21** extending in the y direction and the strip conductor **10** extending in the x direction as shown in FIGS. **2(c)** and **2(d)****.** The planar array antenna may include slots and strip conductors of any other configuration. A planar array antenna **101'** shown in FIGS. **17(a)** to **17(e)** includes a cross-shaped opening **21b** that is provided in the first ground conductor layer **20** and includes intersecting slots extending in the x direction and the y direction. Moreover, the planar array antenna **101'** includes a strip conductor **10** extending in the x direction and a strip conductor **10b** extending in the y direction corresponding to the cross-shaped opening **21b.** The strip conductor **10** and the strip conductor **10b** are arranged with a dielectric layer interposed therebetween so that they cross each other as seen from the z direction.

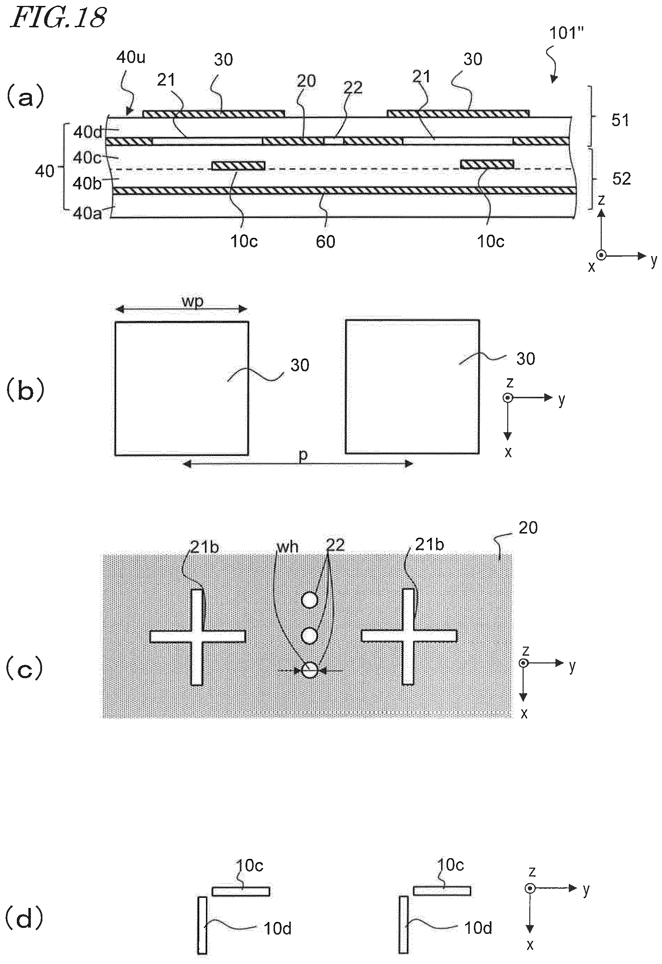

A planar array antenna **101"** shown in FIGS. **18(a)** to **18(d)** includes a cross-shaped opening **21b,** as does the planar array antenna **101',** but the strip conductor configuration is different from the planar array antenna **101'.** The planar array antenna **101"** includes a strip conductor **10d** extending in the x direction and a strip conductor **10c** extending in the y direction. Although these strip conductors correspond to the cross-shaped opening **21b,** their lengths in the x direction and the y direction are shorter than 1/2 the lengths of the two crossing strips forming the cross shape. For example, the strip conductor **10c** and the strip conductor **10d** can be arranged at positions in the dielectric layer that are at the same distance from the first ground conductor layer **20.**

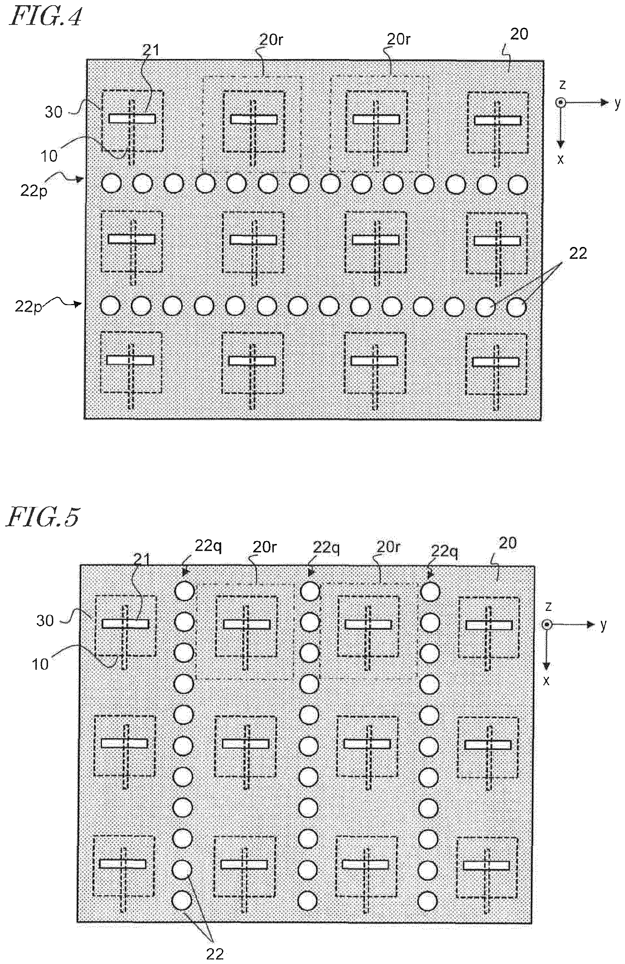

Note that the first ground conductor layer **20** includes both a row **22q** of apertures **22** arranged in the x direction and a row **22p** of apertures **22** arranged in the y direction in the embodiment described above. However, for example, the first ground conductor layer **20** may include only a row **22p** of apertures **22** arranged in the y direction, or may include only a row **22q** of apertures **22** arranged in the x direction, as shown in FIG. **4** and FIG. **5****.** The shape of the aperture **22** is not limited to a circle, but may be a polygonal shape such as a triangle or a rectangle, as long as the apertures **22** have through openings of any shape that are independent of each other.

The number of rows of apertures to be formed in the first ground conductor layer may be one, or may be two or more. One row in the x direction and another row in the y direction may be provided to cross each other to obtain a cross-shaped arrangement, or two rows and two rows may be provided to cross each other to obtain a double-cross-shaped arrangement. A row of apertures may have an equal pitch of apertures, or the aperture interval may be varied or the aperture interval may be random, as long as it is possible to suppress the interference through the first ground conductor layer. The planar array antenna may include apertures or grooves formed in the first ground conductor layer so as to surround the individual antennas.

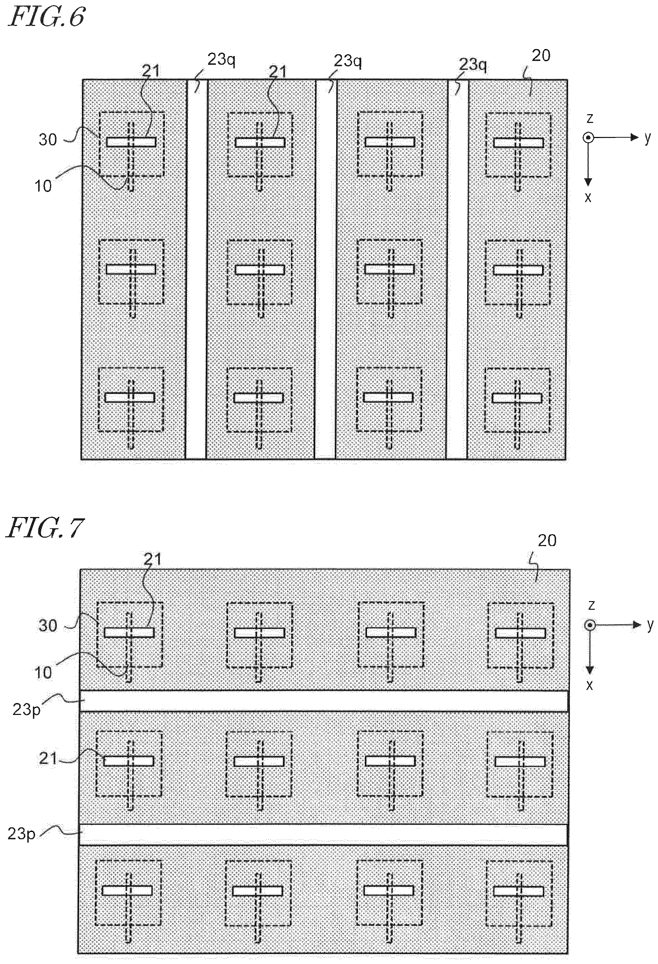

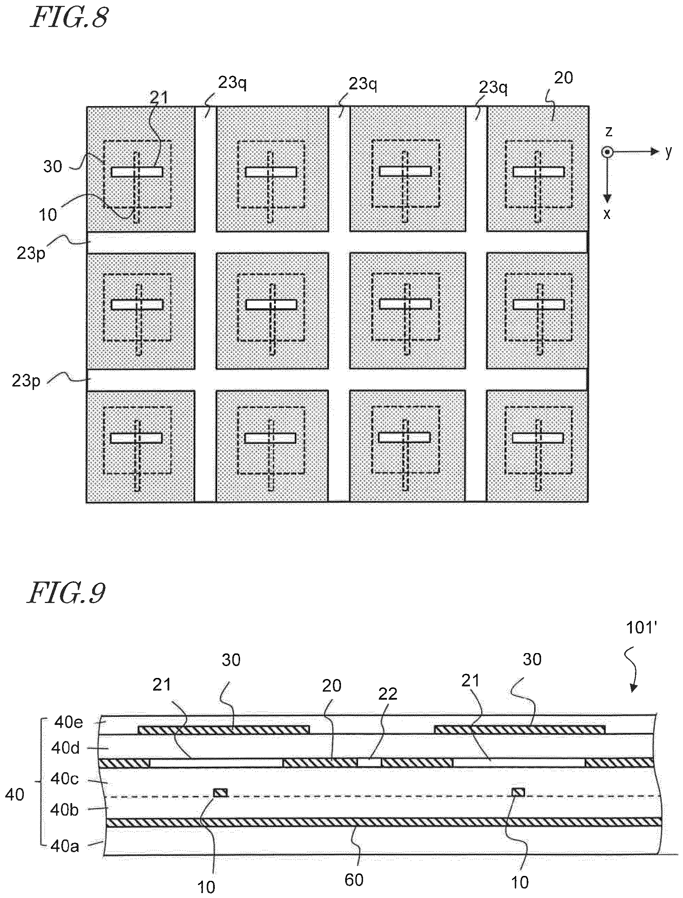

Grooves may be provided instead of the apertures **22.** As FIG. **6** and FIG. **7****,** a groove **23q** extending in the x direction may be provided between two slots **21** in the first ground conductor layer **20** that are adjacent to each other in the y direction, or a groove **23p** extending in the y direction may be provided between two slots **21** in the first ground conductor layer **20** that are adjacent to each other in the x direction. Moreover, as shown in FIG. **8****,** a groove **23p** extending in the y direction and a groove **23q** extending in the x direction may be provided between two slots **21** in the first ground conductor layer **20** that are adjacent to each other in the x direction and between two slots **21** in the first ground conductor layer **20** that are adjacent to each other in the y direction.

The groove **23p** preferably has a depth that is 1/2 or more of the thickness of the first ground conductor layer **20,** and more preferably does not have a bottom. That is, it is preferred that the groove **23p** runs through the first ground conductor layer **20** to divide the first ground conductor layer **20** in a direction that crosses the direction in which the groove **23p** extends. The groove **23p** may reach the two opposing edges that define the outer shape of the first ground conductor layer **20,** or may be a strip-shaped through opening such that the first ground conductor layer **20** is connected in the vicinity of the two opposing edges.

Similarly, planar array antennas including first ground conductor layers **20** of the configurations shown in FIG. **4** to FIG. **8** suppress the electromagnetic interference between planar antennas when the signal power applied to the micro strip line formed by each strip conductor **10** and the second ground conductor layer **60** is electromagnetically coupled to the radiation section **51** via the slot **21.** Thus, the interference of radio waves radiated from the radiation conductors **30** is optimized, also suppressing the decrease in radiation characteristic.

### (Embodiment of planar array antenna using multilayer ceramic substrate)

An embodiment where a planar array antenna is formed by using a multilayer ceramic substrate will now be described. When the planar array antenna **101** is formed by using a multilayer ceramic substrate, the radiation conductors **30,** the first ground conductor layer **20,** the strip conductors **10** and the second ground conductor layer **60** are provided inside or on the surface of the multilayer ceramic body **40,** as shown in FIG. **1** and FIG. **2****.** For example, the multilayer ceramic body **40** includes the ceramic layers **40a** to **40d,** and the second ground conductor layer **60** is located between the ceramic layer **40a** and the ceramic layer **40b.** The strip conductors **10** are located between the ceramic layer **40b** and the ceramic layer **40c,** and the first ground conductor layer **20** is located between the ceramic layer **40c** and the ceramic layer **40d.** The slots **21** and the apertures **22** of the first ground conductor layer **20** may be cavities or may be filled with portions of the ceramic layer **40c** and the ceramic layer **40d.** When the slots **21** and the apertures **22** are filled with portions of the ceramic layer **40c** and the ceramic layer **40d,** the adhesion between the ceramic layer **40c** and the ceramic layer **40d** improves, thereby enhancing the strength of the multilayer ceramic body **40.** The radiation conductors **30** are located on the ceramic layer **40d,** i.e., on the upper surface **40u** of the multilayer ceramic body **40.**

In the multilayer ceramic body **40,** there may not be clear boundaries between the ceramic layers **40a** to **40d.** In such a case, for example, when a non-ceramic component such as the first ground conductor layer **20** is present between two ceramic layers, the position of the first ground conductor layer **20** may be determined to correspond to the boundary between the two ceramic layers. Each of the ceramic layers **40a** to **40d** may correspond to a ceramic green sheet before the ceramic sintering, or may correspond to two or more layers of ceramic green sheets. Below the ceramic layer **40a,** still another ceramic layer may be provided, or conductive vias, a wiring pattern, etc., may be provided. The thickness of each of the ceramic layers **40a** to **40d** is 1 µm or more and 15 mm or less, for example, and is preferably 25 µm or more and 1 mm or less. Then, it is possible to form a planar array antenna of a millimeter wave band and a quasi-millimeter wave band.

In view of the radiation efficiency, it is preferred that the radiation conductors **30** are located on the upper surface **40u** of the multilayer ceramic body **40** and are exposed to the outside. However, in order to protect the radiation conductors **30** from oxidization due to the ambient environment or from damage or deformation due to external forces, the radiation conductors **30** may be covered by the ceramic layer **40e** as shown in (the planar array antenna **101'** of) FIG. **9****.** In order to prevent oxidization, it is an option to plate the radiation conductors **30.** In such a case, however, the plating may lower the conductivity of the radiation conductors **30** and lower the radiation characteristic. In contrast, covering the radiation conductors **30** by the ceramic layer **40e** does not lower the conductivity thereof, and it is therefore possible to realize a greater protection effect than plating, e.g., protection from external forces, while maintaining a level of radiation characteristic that is equal to or greater than that realized by plating.

In this case, the thickness of the ceramic layer **40e** covering the radiation conductors **30** is preferably 70 µm or less. Then, it is possible to realize a level of radiation efficiency that is equal to or greater than that realized with Au/Ni-plated radiation conductors **30,** which are commonly used in planar array antennas. The loss is less as the thickness of the ceramic layer **40e** is smaller, and there is not particular limitation on the lower limit thereof in view of the antenna characteristics. However, if the thickness of the ceramic layer **40e** is too small, it may be difficult to realize a uniform thickness. In order to form the ceramic layer **40e** with a uniform thickness, the thickness of the ceramic layer **40e** is preferably 5 µm, for example. That is, the thickness of the ceramic layer **40e** is more preferably 5 µm or more and 70 µm or less.

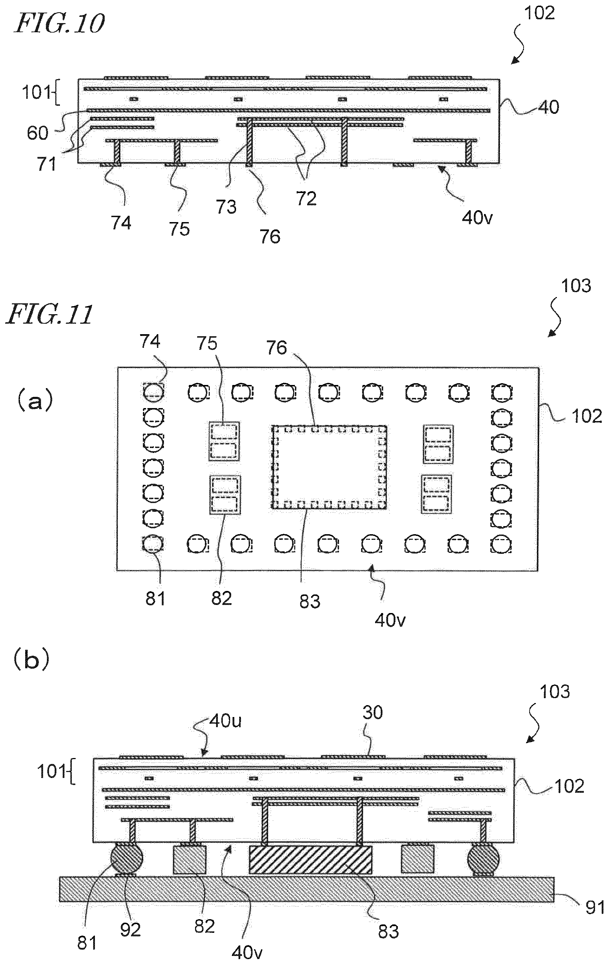

The multilayer ceramic substrate may include other components in addition to the planar array antenna **101.** For example, as shown in FIG. **10****,** the multilayer ceramic substrate **102** may further include, below the second ground conductor layer **60,** a plurality of ceramic layers, and may further include passive element patterns **71,** wiring patterns **72,** conductive vias **73** provided through the ceramic layers. The passive element pattern **71** is a conductive layer or a ceramic having a predetermined resistance value, for example, and forms an inductor, a capacitor, a resistor, a coupler, a distributor, a filter, a power source, or the like. The conductive via **73** and the wiring pattern **72** are connected to the passive element pattern, the ground conductor, etc., to form a predetermined circuit. The multilayer ceramic substrate **102** is a co-fired ceramic substrate obtained by co-firing ceramic layers, conductors such as the radiation conductors **30** of the planar array antenna **101,** the passive element patterns **71,** the wiring patterns **72** and the conductive vias **73.**

An electrode **74** for connection with an external substrate, an electrode **75** for connection with a passive component and an electrode **76** for connection with an active component such as an integrated circuit may be located on a lower surface **40v** of the multilayer ceramic body **40,** for example. The strip conductor **10** may be electrically connected to one of the electrodes **74, 75** and **76** by a conductive via arranged at a position not shown in the figure.

These components provided on ceramic layers that are located on the lower surface side of the second ground conductor layer **60** form a wiring circuit including a passive element. A wireless communication circuit is formed by connecting a passive element, an integrated circuit, etc., to a plurality of electrodes of a wiring circuit described above.

When the planar array antenna **101** is formed by using a multilayer ceramic substrate, it is possible to co-fire the ceramic layers and the conductive layers such as the radiation conductors **30.** That is, the planar array antenna **101** can be formed by using a co-fired ceramic substrate. The co-fired ceramic substrate may be a low temperature co-fired ceramic (LTCC) substrate or a high temperature co-fired ceramic (HTCC) substrate. In view of the high frequency characteristics, there may be cases where it is preferred to use a low temperature co-fired ceramic substrate. A ceramic material and a conductive material selected in accordance with the sintering temperature, the application, etc., the frequency of wireless communication, etc., are used for the ceramic layer, the radiation conductor, the ground conductor, the strip conductor, the passive element pattern, the wiring pattern and the conductive via of the multilayer ceramic structure. A conductive paste for forming the radiation conductor, the ground conductor (specifically, a ground conductor layer), the strip conductor, the passive element pattern, the wiring pattern and the conductive via and a green sheet for forming a ceramic layer of the multilayer ceramic structure are co-fired. When the co-fired ceramic substrate is a low temperature co-fired ceramic substrate, a ceramic material and a conductive material that can be sintered in a temperature range of about 800°C to about 1000°C are used. For example, the ceramic material used may be a ceramic material including Al, Si and Sr as its main components and at least one of Ti, Bi, Cu, Mn, Na and K as its sub-components, a ceramic material including Al, Si and Sr as its main components and at least one of Ca, Pb, Na and K as its sub-components, a ceramic material including Al, Mg, Si and Gd, and a ceramic material including Al, Si, Zr and Mg. The conductive material used may be a conductive material including Ag or Cu. The dielectric constant of the ceramic material is about 3 to about 15. When the co-fired ceramic substrate is a high temperature co-fired multi-layer ceramic substrate, a ceramic material including Al as its main components, and a conductive material including W (tungsten) or Mo (molybdenum) may be used.

More specifically, the LTCC material may be for example any of various materials including a low dielectric constant (dielectric constant: 5 to 10) Al-Mg-Si-Gd-O-based dielectric material, a dielectric material made of a crystal phase made of Mg₂SiO₄ and an Si-Ba-La-B-O-based glass, or the like, an Al-Si-Sr-O-based dielectric material, an Al-Si-Ba-O-based dielectric material, a high dielectric constant (dielectric constant: 50 or more) Bi-Ca-Nb-O-based dielectric material, etc.

For example, if an Al-Si-Sr-O-based dielectric material includes an oxide of Al, Si, Sr or Ti as its main component, it is preferred that it includes Al₂O₃: 10 to 60% by mass, SiO₂: 25 to 60% by mass, SrO: 7.5 to 50% by mass or TiO₂: 20% by mass or less (including 0), where the main components, Al, Si, Sr and Ti, are converted to Al₂O₃, SiO₂, SrO and TiO₂, respectively. With respect to 100 parts by mass of the main component, it is preferred to include, as its sub-component, at least one of the group of Bi, Na, K and Co by an amount of 0.1 to 10 parts by mass in terms of Bi₂O₃, 0.1 to 5 parts by mass in terms of Na₂O, 0.1 to 5 parts by mass in terms of K₂O, or 0.1 to 5 parts by mass in terms of CoO, and further include at least one of the group of Cu, Mn and Ag by an amount of 0.01 to 5 parts by mass in terms of CuO, 0.01 to 5 parts by mass in terms of Mn₃O₄, or 0.01 to 5 parts by mass of Ag. In addition, unavoidable impurities may be included.

The ceramic layers of the multilayer ceramic body **40** may have the same composition and be formed from the same material. Alternatively, in order to increase the radiation efficiency of the planar antenna, ceramic layers in the vicinity of the radiation conductor of the multilayer ceramic body **40** may have a different composition and be formed from a different material from ceramic layers below the ceramic layers. As they have different compositions, they can have different dielectric constants, and it is therefore possible to improve the radiation efficiency.

The radiation conductors **30** may be covered by a layer made of a resin, a glass, or the like, other than a ceramic layer, and the multilayer ceramic body **40** may be combined with a circuit substrate made of a resin, a glass, or the like, thereby forming a composite substrate.

The co-fired ceramic substrate may be manufactured by using a similar manufacturing method as an LTCC substrate or an HTCC substrate.

For example, first, a ceramic material including elements as described above is prepared and subjected to preliminary sintering at 700°C to 850°C, for example, as necessary, and pulverized into grains. A glass component powder, an organic binder, a plasticizer and a solvent are added to the ceramic material, thereby obtaining a slurry of the mixture. When different materials are used to form ceramic layers in order to realize different dielectric constants, for example, two different slurries including different materials are prepared. A powder of the conductive material described above is mixed with an organic binder and a solvent, etc., thereby obtaining a conductive paste.

A layer of the slurry having a predetermined thickness is formed on a carrier film by using a doctor blade method, a rolling (extrusion) method, a printing method, an inkjet application method, a transfer method, or the like, and the layer is dried. The slurry layer is severed to obtain ceramic green sheets.

Next, in accordance with a circuit to be formed in the co-fired ceramic substrate, via holes are formed in the plurality of ceramic green sheets by using a laser, a mechanical puncher, or the like, and the via holes are filled with a conductive paste by using a screen printing method. A conductive paste is printed on the ceramic green sheets by using a screen printing, or the like, to form a wiring pattern, a passive element pattern, a radiation conductor pattern, first and second ground conductor layer patterns, and a strip conductor pattern on the ceramic green sheet.

The ceramic green sheets with the conductive paste described above arranged thereon are sequentially laminated together with preliminary pressure-bonding therebetween, thereby forming a green sheet laminate. Then, the binder is removed from the green sheet laminate, and the debindered green sheet laminate is co-fired. Thus, the co-fired ceramic substrate is completed.

The co-fired ceramic substrate produced as described above includes a wiring circuit, a passive element and a planar array antenna for millimeter wave wireless communication. Therefore, by mounting a chip set, or the like, for millimeter wave wireless communication on the co-fired ceramic substrate, it is possible to realize a wireless communication module that includes an antenna.

When the ceramic layer on the surface of the multilayer ceramic body completely covers the entirety of the radiation conductor, it is possible to protect the radiation conductor from the ambient environment and external forces, and it is possible to suppress the decrease in radiation efficiency and the change in antenna characteristics.

Note that the shape, the number and the arrangement of the radiation conductor, the ground conductor and the strip conductors of the planar array antenna described in the present embodiment are merely schematic examples. For example, some of the radiation conductors may be arranged at the interface of the ceramic layer that is located at a different distance from the ground conductor. The radiation conductors may be provided with slots. The planar array antenna may further include conductors to which no electricity is supplied, in addition to the radiation conductors, and the conductors may be layered with the radiation conductors with a ceramic layer interposed therebetween.

### (Second embodiment)

An embodiment of a quasi-millimeter wave/millimeter wave wireless communication module will be described. FIG. **11(a)** is a schematic bottom view showing an embodiment of a wireless communication module of the present disclosure, and FIG. **11(b)** is a schematic cross-sectional view showing a wireless communication module mounted on a substrate. A wireless communication module **103** includes the multilayer ceramic substrate **102** of the first embodiment, a solder bump **81,** a passive component **82,** and an active component **83.** The solder bump **81** is provided at the electrode **74** located on the lower surface **40v** of the multilayer ceramic substrate **102.** The passive component **82** is a chip capacitor, a chip inductor, a chip resistor, or the like, for example, and is attached to the electrode **75** via a solder, or the like. The active component **83** is a chip set for wireless communication, for example, and is a receiving circuit, a transmitting circuit, an A/D converter, a D/A converter, a baseband processor, a medium access controller, etc, and it is attached to the electrode **76** via a solder, or the like.

The wireless communication module **103** is attached to a circuit substrate **91** with an electrode **92** provided thereon, for example, by flip-chip bonding, facing down, i.e., so that the passive component **82** and the active component **83** oppose the circuit substrate **91.** As the electrode **92** of the circuit substrate **91** and the electrode **74** of the multilayer ceramic substrate **102** are electrically connected to each other by the solder bump **81,** the multilayer ceramic substrate **102** is electrically connected to an external power supply circuit and other modules.

In the wireless communication module **103** mounted on the circuit substrate **91,** the upper surface **40u** of the multilayer ceramic substrate **102** is located on the opposite side from the circuit substrate **91.** Therefore, it is possible to radiate a radio wave of a quasi-millimeter wave and millimeter wave band from the radiation section **51** (as shown in FIG. **1**) and to receive a radio wave of a quasi-millimeter wave and millimeter wave band coming from outside by the radiation section **51,** without being influenced by the passive component **82** and the active component **83** or the circuit substrate **91.** Thus, it is possible to realize a small-sized wireless communication module including an antenna that can be surface mounted.

### (Example calculation of planar array antenna characteristics)

The results of calculation for the characteristics of the planar array antenna of the first embodiment will be described.

The radiation characteristics of planar array antennas of Example 1 to Example 5, which are varied as shown in Table 1 in terms of the type and the direction of arrangement of the openings provided in the first ground conductor layer, were determined by calculation. The conditions used for the calculation are as follows.
Material of radiation conductor: Silver
Slot size: 1.6 mm (y direction) x 0.5 mm (x direction)
Radiation conductor size: 2 mm (y direction) x 0.5 mm (x direction)
Diameter of aperture or width of groove: 100 µm
Pitch **p** of radiation conductor **30:** 2.5 mm (λ/2 of 60 GHz band)
Dielectric constant of multilayer ceramic body **40:** 6

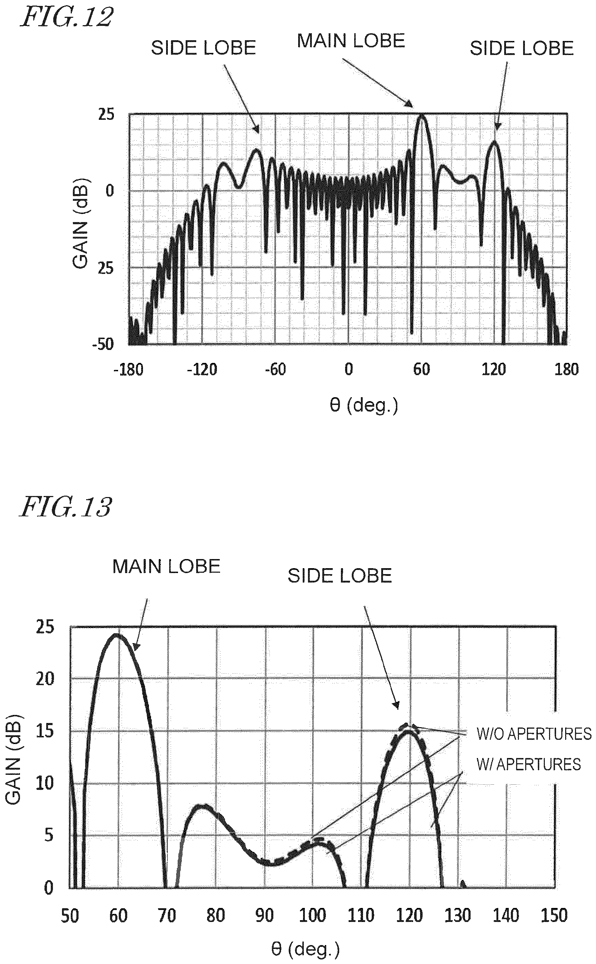

FIG. **12** to FIG. **16** show the calculated radiation characteristics of the planar array antennas. Table 1 show the correspondence between the types and the directions of arrangement of the openings provided in the first ground conductor layer and the figures showing the radiation characteristics. In FIG. **12** to FIG. **16****,** the horizontal axis represents the angle in the xz plane where the coordinates are assumed as shown in FIG. **1****,** wherein the -z axis direction is -180° and +180° and the +z axis direction is 0°, and the vertical axis represents the gain.

**[Table 1]**

| Samples | Opening type | Direction of arrangement | Figure |
|---|---|---|---|
| Example 1 | Aperture | x direction and y direction | 12 |
| Example 2 | Aperture | x direction | 13 |
| Example 3 | Groove | x direction | 14 |
| Example 4 | Groove | y direction | 15 |
| Example 5 | Groove | x direction and y direction | 16 |

FIG. **12** shows the radiation pattern of the gain in the xz plane of electromagnetic waves radiated from the planar array antenna of Example 1. As shown in FIG. **12****,** the gain is highest around 60°. This peak around 60° is referred to as the main lobe. In addition, there are peaks also around -75° and 120°, and they are referred to as side lobes. Typically, an array antenna is required to have a high directionality of electromagnetic waves to be radiated or received. Therefore, the radiation of electromagnetic waves observed at side lobe angles are unnecessary waves, and the gain difference between the main lobe peak and the side lobes is preferably large in order to realize a high directionality. In the calculation example shown in FIG. **12****,** the gain difference between the main lobe and the side lobes is about 8 dB. FIG. **13** shows the radiation pattern of the gain in the xz plane of electromagnetic waves radiated from the planar array antenna of Example 2. FIG. **13** and subsequent figures show the radiation pattern of the gain in a range from 50° to 150° including the main lobe and a side lobe of the next highest gain. FIG. **13** also shows the radiation characteristic where no opening is provided in the first ground conductor layer **20** for the purpose of comparison.

As shown in FIG. **13****,** the gain of the main lobe does not substantially differ between a case where no opening is provided (hereinafter referred to as the reference example) and Example 2. However, the gain of the side lobe is lower by about 1 dB for Example 2. That is, the gain difference between the main lobe and the side lobe is larger in Example 2 as compared with the reference example, and Example 2 has an increased directionality of the radiation characteristic.

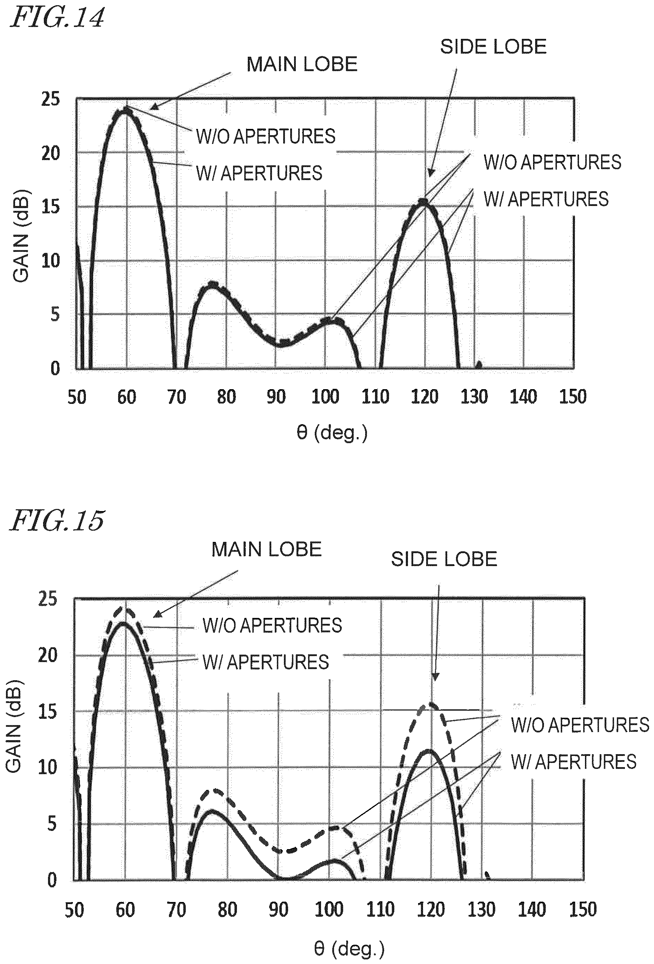

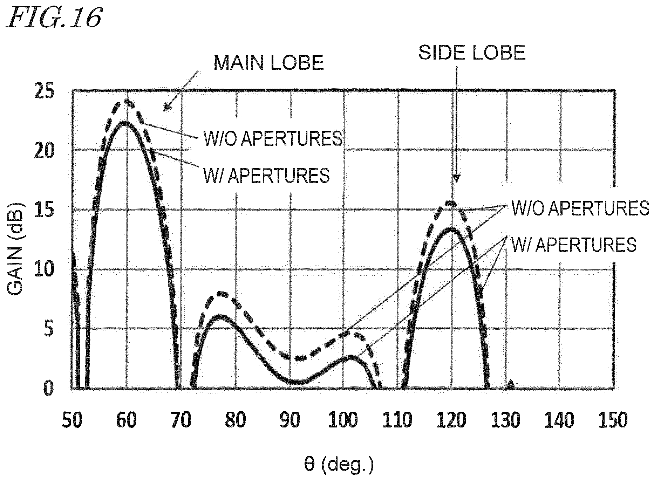

FIG. **14** to FIG. **16** each show the radiation characteristic where grooves are provided as openings in the first ground conductor layer **20.** As shown in FIG. **14****,** in this calculation example, when the grooves are provided in the x direction, the provision of the openings improves the radiation characteristic. Note that the openings also contribute to the suppression of the interference between adjacent slots. In contrast, as shown in FIG. **15** and FIG. **16****,** where the grooves are provided at least in the y direction, the grooves in the y direction, which cross the direction of resonance of the antenna (the x direction), block the resonance, and the provision of the openings can therefore increase the difference between the gain of the side lobe and the gain of the main lobe. Specifically, in Example 4, while the decrease in the gain of the main lobe is about 1 dB, the decrease in the gain of the side lobe is about 4 dB. In Example 5, while the decrease in the gain of the main lobe is about 1.5 dB, the decrease in the gain of the side lobe is about 2 dB. Therefore, particularly in Examples 4 and 5, the directionality of the radiation characteristic is increased as compared with the reference example.

### REFERENCE SIGNS LIST

- 10: Strip conductor
- 20: First ground conductor layer
- 20r: Region
- 21: Slot
- 22: Aperture
- 22p, 22q: Row
- 23p, 23q: Groove
- 30: Radiation conductor
- 30r: Region
- 40: Multilayer ceramic body
- 40a to 40e: Ceramic layer
- 40u: Upper surface
- 40v: Lower surface
- 51: Radiation section
- 52: Power supply section
- 60: Second ground conductor layer
- 71: Passive element pattern
- 72: Wiring pattern
- 73: Conductive via
- 74 to 76: Electrode
- 81: Solder bump
- 82: Passive component
- 83: Active component
- 91: Circuit substrate
- 92: Electrode
- 93: Seal resin
- 101, 101': Planar array antenna
- 102: Multilayer ceramic substrate
- 103: Wireless communication module

## Claims

1. A planar array antenna comprising:
a radiation section including a plurality of radiation conductors and a first ground conductor layer; and
a power supply section including a plurality of strip conductors and a second ground conductor layer, wherein:
the strip conductors are arranged so as to correspond to the radiation conductors between the first ground conductor layer and the second ground conductor layer; and
the first ground conductor layer is located between the radiation conductors and the corresponding strip conductors, and includes a plurality of slots extending in a direction that crosses a direction in which the strip conductor extends and a groove or at least one aperture located between adjacent two of the slots.

2. The planar array antenna according to claim 1, wherein the radiation conductors and the strip conductors are arranged two-dimensionally in a first direction and in a second direction perpendicular to the first direction.

3. The planar array antenna according to claim 2, wherein the first ground conductor layer has a plurality of apertures, and the apertures are arranged in the first direction and in the second direction.

4. The planar array antenna according to claim 2, wherein the first ground conductor layer has a plurality of apertures, and the apertures are arranged only in one of the first direction and the second direction.

5. The planar array antenna according to claim 2, wherein the first ground conductor layer has a plurality of grooves, and the grooves are arranged in the first direction and in the second direction.

6. The planar array antenna according to claim 2, wherein the first ground conductor layer has a plurality of grooves, and the grooves are arranged only in one of the first direction and the second direction.

7. The planar array antenna according to any one of claims 1 to 6, further comprising dielectric layers located between the radiation conductors and the first ground conductor layer, between the first ground conductor layer and the strip conductors, and between the strip conductors and the second ground conductor layer.

8. The planar array antenna according to any one of claims 1 to 6, further comprising:
a plurality of ceramic layers, wherein:
the radiation conductors, the first ground conductor layer, the strip conductors and the second ground conductor layer are located between the ceramic layers.

9. The planar array antenna according to any one of claims 1 to 8, further comprising a dielectric layer that covers the radiation conductors.

10. The planar array antenna according to any one of claims 1 to 9, wherein the grooves or at least one aperture of the first ground conductor layer are cavities.

11. The planar array antenna according to any one of claims 1 to 9, wherein the grooves or at least one aperture of the first ground conductor layer are filled with the same ceramic as a ceramic of the ceramic layers.

12. A quasi-millimeter wave/millimeter wave wireless communication module comprising:
the planar array antenna according to any one of claims 1 to 11; and
an active component that is electrically connected to the planar array antenna.
